# EUROPÄISCHE PATENTSCHRIFT

(11) **EP 1 001 461 B1**
(45) Veröffentlichungstag und Bekanntmachung des Hinweises auf die Patenterteilung: **20.02.2008**
(21) Anmeldenummer: 99120312.6
(22) Anmeldetag: 12.10.1999
(51) Int. Cl.: H01L 23/29, H01L 23/31, H01L 21/314, H01L 29/06

(54) **Verfahren zur Passivierung einer schnellen Leistungsdiode durch eine Passivierungsschicht aus amorphem Kohlenstoff**
Passivation method of a high-speed power diode by means of an amorphous carbon passivation layer
Méthode de passivation d'une diode rapide de puissance par une couche de passivation en carbone amorphe

(30) Priorität: 09.11.1998 DE 19851461
(43) Veröffentlichungstag der Anmeldung: 17.05.2000
(73) Patentinhaber: SEMIKRON Elektronik GmbH & Co. KG, 90431 Nürnberg (DE)
(72) Erfinder: Lutz, Josef, 90443 Nürnberg (DE); Lang, Manfred, Dr., 91126 Schwabach (DE)

(56) Entgegenhaltungen:
- EP-A- 0 381 111
- DE-A- 4 310 444
- DE-A- 4 410 354
- BARTHELMESS R ET AL: "Electroactive passivation of high power semiconductor devices with punch through design by hydrogenated amorphous carbon layers (a-C:H)" PROCEEDINGS OF THE 10TH INTERNATIONAL SYMPOSIUM ON POWER SEMICONDUCTOR DEVICES AND ICS (ISPSD '98) (IEEE CAT. NO.98CH36212), KYOTO, JP, 3. - 6. Juni 1998, Seiten 181-184, XP000801060 Inst. Electr. Eng. Japan, Tokyo, JP, ISBN: 0-7803-4752-8
- FRISCHHOLZ M ET AL: "OBIC MEASUREMENTS ON PLANAR HIGH VOLTAGE P+-N JUNCTIONS WITH DIAMOND-LIKE CARBON FILMS AS PASSIVATION LAYER" DIAMOND AND RELATED MATERIALS, Bd. 2, Nr. 5-7, 13. April 1993 (1993-04-13), Seiten 778-781, XP000414262 ELSEVIER SEQUOIA SA, LAUSANNE, CH ISSN: 0925-9635
- MASSI M ET AL: "Effects of plasma etching on DLC films" 14TH INT VACUUM CONGRESS (IVC-14). 10TH INT CONF ON SOLID SURFACES (ICSS-10). 5TH INT CONF ON NANOMETRE-SCALE SCIENCE AND TECHNOLOGY (NANO-5). 10TH INT CONF ON QUANTITATIVE SURFACE ANALYSIS, BIRMINGHAM, GB, Bd. 343-344, 31. August 1998 (1998-08-31) - 4. September 1998 (1998-09-04), Seiten 381-384, XP002131416 Thin Solid Films, April 1999, Elsevier, Lausanne, CH, ISSN: 0040-6090

## Beschreibung

Die Erfindung beschreibt ein Verfahren zur Passivierung einer schnellen Leistungsdiode für hohe Sperrspannungen nach dem Anspruch 1.

Leistungshalbleiterbauelemente wie Schalttransistoren und Leistungsdioden hoher Zuverlässigkeit und Verfahren zu deren Herstellung einschließlich einer Passivierung, die Sperrspannungen von mehr als 1.700 bis zu 6.500 Volt ermöglichen, werden insbesondere zum Aufbau leistungsstarker Stromumrichter benötigt.

Zur Realisierung sehr hoher Sperrfähigkeiten sind Passivierungen der Halbleiterbauelemente in deren Herstellungsprozeß von einer wesentlichen Bedeutung. Man unterscheidet zwei Hauptrichtungen:
1. Passivierungsverfahren mit einer **Mesa- Struktur**, bei denen eine geschaffene Randkontur mit einem definierten Winkel erzeugt wird. Dabei wird der parallel zur Oberfläche des Bauelementes verlaufende pn- Übergang durch die Randstruktur in einem definierten positiven oder negativen Randwinkel geschnitten. Es erfolgt eine Aufweitung der Raumladungszone an der Oberfläche. Eine Übersicht dazu wird von W. Gerlach, Thyristoren, Berlin 1979, gegeben.
   Die Herstellung geometrisch geschliffener Randkonturen erfolgt dem Stand der Technik entsprechend an jedem Einzelchip als gesonderter Prozeßschritt. Sie ist daher für großflächige Leistungsbauelemente (5cm² bis zu fast 100cm²) üblich, die Stromtragfähigkeit liegt zwischen 300A und 4.000A, die typischen Sperrspannungen liegen zwischen 2.000 und 9.000V. Solche Bauelemente werden im weiteren Aufbau überwiegend druckkontaktiert verarbeitet und nach der Passivierung keinen Temperaturbeanspruchungen von größer als 250°C ausgesetzt.
2. **Planare Passivierungsstrukturen** werden auf der ebenen (planaren) Oberfläche des Halbleiterbauelementes aufgebracht. Auch hier wird eine Aufweitung der Raumladungszone in den Randbereichen jedes einzelnen Bauelementes erzeugt. Sie können in drei Arten unterschieden werden:
   2.1 Die Planarstruktur mit eindiffundierten floatenden Potentialringen. Sie wird von Y.C.Kao, E.D.Wolley: "High Voltage Planar pn- Junctions", Proceedings of the IEEE, Vol. 55, 1409, (1967), beschrieben. Hier bewirken eindiffundierte Potentialringe eine Aufweitung der Raumladungszone.
   2.2 Die Planarstruktur nach dem RESURF-(Reduced Electrical Surface Field)- Prinzip. Hier schließt sich an eine p- Zone hoher Dotierung eine eindiffundierte p⁻- Zone niedriger Dotierung an, die so ausgelegt ist, das der Hauptanteil des elektrischen Feldes in der p⁻- Zone aufgenommen wird.
      Ein Spezialfall davon ist die VLD- Struktur (Variation of Lateral Doping), die von R. Stengl, U. Gösele: "Variation of Lateral Doping - a new Concept to Avoid High Voltage Breakdown of Planar Junctions", IEEE IEDM 85, S.154 (1985), vorgeschlagen wurde.
   2.3 Die Planarstruktur mit Feldplatten zur Aufweitung der Raumladungszone. Durch definiert eingestellte Stufen in einem Isolator über der Halbleiteroberfläche wird die Raumladungszone aufgeweitet.

Die planaren Strukturen werden im Waferverbund einer Vielzahl von Bauelementen hergestellt. Der Haupteinsatz moderner Leistungsbauelemente geht zur Parallelschaltung mehrerer Einzelchips. Die typische Größe planarer Chips liegt zwischen 0,1 und 2cm². Hier sind nur solche Bauelemente zu vertretbaren Kosten herstellbar, die im Waferverbund gefertigt werden.

Bei der Fertigung im Waferverbund wird die Passivierung und ihr entsprechender Schutzüberzug vor der Metallisierung hergestellt. Dadurch muß die Passivierungsschicht stabil gegen den Temperprozeß der Metallisierung sein. Die Metallisierung ist zumindest auf einer Seite des späteren Chips lötfähig gestaltet. Lötfähige Metallisierungen müssen dem Stand der Technik entsprechend bei Temperaturen von mindestens >360°C, in der praktizierten Technologie bei >400°C getempert werden.

Sowohl die geometrisch geformten als auch die planaren Randkonturen von Halbleiterkörpern müssen mit einer isolierenden oder semiisolierenden Schutzschicht zum Erreichen der Sperrfähigkeit und zum Schutz vor negativen Umgebungseinflüssen versehen werden. Dabei sind sowohl die Vorbehandlung des Wafers als auch die Eigenschaften dieser Passivierungsschicht kritisch.

In DE 28 53 797 (1978) wird dargestellt, daß die bei Raumtemperatur unvermeidlich entstehende dünne Oxidschicht zur Verschlechterung des Sperrvermögens der Bauelemente nach Strombelastung führen kann, weshalb eine geeignete chemische Vorbehandlung erforderlich ist. Als Schutzschichten selbst sind bei Mesa- Randkonturen organische Passivierungschichten nach dem Stand der Technik üblich.

Bei planaren Randstrukturen sind wegen der nachfolgenden Temperaturbelastungen mit Temperaturen von größer als 400°C anorganische Passivierungsschichten aus SiO₂ und Si₃N₄ nach dem Stand der Technik üblich. Weiterhin bietet es sich an, eine Glasschicht, die neben SiO₂ auch Metalloxyde enthält, zu verwenden, wie das in DE 44 10 354 A1 beschrieben ist. Moderne Verfahren verwenden hier auch semiisolierende Polysiliziumschichten.

Die Anforderungen an die Zuverlässigkeit der Passivierungsschichten steigen wegen der Forderung nach Halbleiterbauelementen mit immer höheren Sperrspannungen. Alle Halbleiterbauelemente werden einem mindestens 1.000- stündigen Test bei Gleichspannung nahe dem vollen Sperrvermögen und bei Temperaturen gleich oder nahe der maximal zulässigen Temperatur (125°C bis 175°C) ausgesetzt. Dabei dürfen sich ihre Sperreigenschaften nicht verändern

Bei Verwendung von SiO₂ als Oberflächenpassivierung wird beobachtet, daß bereits ab einer Sperrspannung von 1.200 Volt ein Anstieg des Sperrstroms bei einem statistischen Anteil der getesteten Bauelemente zu verzeichnen ist. Bei additiv aufgetragenem und gesintertem Glas wird ab Sperrspannungen von größer 1.700 Volt ein vergleichbarer Anstieg beobachtet. Als Ursache dieses Sperrstromanstiegs werden langsam bewegliche Ladungsträger angenommen, die unter den hohen elektrischen Feldern und der langen Testzeit ihre Position verändern, was schließlich zu einem Verlust der Sperrfähigkeit des Halbleiterbauelements führt, bzw. führen kann.

Diese beweglichen Ladungen (insbesondere Alkaliionen), vornehmlich Verunreinigungen der Luft, der Reaktionsbecken und der verwendeten Einrichtungen im Herstellungsprozeß, können durch technologischen Aufwand reduziert, aber kaum vollständig beseitigt werden. Je höher die Sperrspannungsanforderungen sind, desto geringer ist die ausreichende Schwellen-Ladungsmenge, um bei Langzeitbelastung ein Driften der Kennlinie zu verursachen.

Zur Beseitigung der Kennliniendrift können semiisolierende Polysilizium- Schichten verwendet werden. Allerdings wurde die Erfahrung gemacht, daß solche Schichten in Verbindung mit planaren Feldringen immer zu niedrigeren Sperrspannungen führen, als sie von dem Bauelement bedingt durch dessen konstruktiver Auslegung seines Volumens und seiner Randkontur zu erwarten und möglich wären.

Die Verwendung amorphen Halbleitermaterials als Passivierungsschicht wird in DE 44 28 524 A1 beschrieben. Dabei ist dort eine geschliffene Randstruktur zugrundegelegt worden. Als amorphes Halbleitermaterial wird dort aufgedampftes und getempertes Silizium verwendet, das mit 10¹⁹ bis 10²⁰cm⁻³ Bor dotiert ist. Die Bordotierung dient dazu, eine n- Dotierung in der Passivierungsschicht, die Inversionskanäle in einer in der Struktur des Halbleitervolumens vorhandenen p-dotierten Zone hervorrufen könnte, zu vermeiden.

Es soll u.a. die Bedingung erfüllt werden, daß das Verhältnis von Sperrstromdichte des Heteroübergangs zur Leitfähigkeit der Passivierungsschicht größer ist als der maximale Feldgradient an der Oberfläche des Bauelementes multipliziert mit der Dicke der Passivierungsschicht. Die o.g. Vorveröffentlichung beinhaltet den Hinweis, daß an Stelle von amorphem dotiertem Silizium in gleicher Weise hydrierter Kohlenstoff verwendet werden kann. Nach diesem Stand der Technik werden die amorphen Halbleiterschichten entsprechend mit Bor dotiert, um der erwähnten Ungleichung zu genügen.

In DE 44 28 524 A1 wird ausgeführt, daß an Stelle einer Dotierung mit Bor eine Dotierung mit Sauerstoff zwischen 0,01% und 20% verwendet werden kann, um prozeßtechnische und umweltgefährdende Problemlösungen der für eine Bordotierung verfügbaren Dotierquellen zu vermeiden, denn genannte Dotierquellen sind hochgradig giftig. Nach der Abscheidung wird die Schicht bei einer Temperatur zwischen 200°C und 350°C getempert.

Die Herstellung von Schichten aus amorphem, hydriertem Kohlenstoff (a-C:H) durch Abscheidung aus einem Kohlenwasserstoff- Plasma wird erstmals von Holland und Ohja in der Zeitschrift Thin Film Solids 38, L17 (1 976) beschrieben. Die Passivierung "a-C:H" besteht aus Kohlenstoff in einer Mischung aus einem sp²- und sp³- Hybrid, sowie aus mit Wasserstoff gesättigten Bindungen.

Die Eigenschaften der Schichten können hauptsächlich durch die sich in einem Plasma- Reaktor einstellende Self- Bias- Spannung gesteuert werden, wodurch die kinetische Energie der auftreffenden CHₓ- Ionen und damit das Schichtwachstum bestimmt wird.

Die hervorragenden Eigenschaften von a-C:H- Oberflächen als Passsivierungschicht von Halbleiterbauelementen werden in den Dissertationen von T. Mandel, Erlangen 1994 und R. Barthelmeß, Erlangen 1995 ausführlich beschrieben.

Barhelmeß et al beschreiben in "Proc. of the 10th Int. Sym. on Power Semiconductor Devices and ICs (ISPSD), Kyoto, JP, 3. - 6. Juni 1998, Seite 181-184" besipielhaft Leistungsbauelemente für Sperrspannungen im Bereich einiger Kilovolt, hier vorzugsweise 6,5kV, die mittels einer (a:C-H) Schicht passiviert wurden. Mittels dieser Passivierung sind auch bei sehr speziell aufgebauten Dioden hohe Sperrspannungen mit vorteilhaften Eigenschaften gegenüber konventionell passivierten Dioden erzielbar.

a-C:H- Schichten weisen eine große Zahl umladbarer Zustände in der Bandlücke auf Bei Vorhandensein einer durch eine Verunreinigung verursachte Ladung bildet sich in der a-C:H-Schicht eine Gegenladung. Diese Gegenladungen können auch in der Randkontur auftretende Feldspitzen reduzieren. Daher werden a-C:H- Schichten auch als elektroaktive Passivierung bezeichnet, sie lassen damit eine hohe Zuverlässigkeit bei Gleichspannungsbelastung, eine hohe Sperrspannung sowie auch eine hohe Ausbeute im Herstellprozeß erwarten.

Vorgenannte Arbeiten zeigen leider auch auf, daß bei anschließender Temperung der a-C:H-Schichten eine partielle "Graphitisierung" ab einer Temperatur von 300°C einsetzt, deren prozentualer Anteil mit der Temperaturerhöhung zunimmt. Dabei werden sp³- zu sp²-Bindungen (Graphit- Bindungen) umgewandelt, wodurch diese Schicht ihre Eigenschaft als Isolator verliert.

Durch diese Tatsache bedingt hat sich das Verfahren bisher nur bei Bauelementen durchgesetzt, die nach der Abscheidung der a-C:H- Schicht keinen Temperaturbelastungen im Bereich von größer als 350°C ausgesetzt sind. Dies ist beispielhaft bei den oben beschriebenen Halbleiterbauelementen mit Mesa- Randkonturen der Fall, die überwiegend in Druckkontakttechnik weiter zu kompletten Bauelementen aufgebaut werden. Ein Verfahren zur Herstellung von a-C:H-Schichten bei planaren Oberflächenstrukturen ist aus praktizierter Technologie nicht bekannt Bekannte Verfahren nach dem Stand der Technik gestalten die a-C:H- Schicht mit Dotierungen. Bei Verwendung von Bordotanten erfordert dies eine Zuführung von Gasen wie Diboran oder anderen Bor enthaltenden Verbindungen im Plasma- Prozeß, was verfahrenstechnisch Unsicherheiten verursacht und einen erheblichen technischen Aufwand erfordert. Bei Verwendung von Sauerstoff enthaltenden Kohlenwasserstoffverbindungen ist ebenfalls aufgrund der explosiven Eigenschaften ein erheblicher technischer und technologischer Aufwand erforderlich.

Die a-C:H- Schicht ist aufgrund ihrer diamantähnlichen Struktur chemisch inert und daher mit chemischen Verfahren der Halbleitertechnologie aufwendig zu strukturieren. Die Strukturierung ist für eine planare Prozeßfuhrung jedoch unerläßlich, da hier die a-C:H- Schicht in einer exakt justierten Position auf der Randkontur des einzelnen Bauelementes angeordnet sein muß.

Die vorliegende Erfindung hat die Aufgabe, Verfahren zur Herstellung einer schnelle Leistungsdiode mit einer a-C:H- Schicht auf einer Planarstruktur vorzustellen, wobei die a-C:H-Schicht und ihre Anordnung so beschaffen sein soll, daß sie in ihrer Strukturierung und Formgestaltung kompatibel zu den Bearbeitungsstufen der übrigen planaren Strukturierung im Waferverbund ist, daß keine Dotierung dieser Schicht erforderlich ist, daß eine anschließende Temperaturbehandlung dieser Schicht bis zu 440°C zum Erzielen einer lötfähigen Matallisierung möglich ist und daß sie in gleicher Weise zu den Methoden der Einstellung der Trägerlebensdauer durch Bestrahlen mit Elektronen, Protonen oder He⁺⁺- Ionen mit dem sich anschließenden Tempern kompatibel ist.

Diese Aufgabe wird durch die Maßnahmen des Anspruchs 1 gelöst, vorteilhafte Ausfiihrungsvarianten zur Erzeugung und zu der Bildung von strukturierten a-C:H-Schichten sind in den nachgeordneten Ansprüchen aufgezeigt.

Es wurde ein technologisches Prozeßfenster gefunden, bei dem die a-C:H- Schicht auf einem Wafer mit Planarstruktur auch in den Folgeprozessen mit Temperaturen >300°C bis hin zu 440°C ausgesetzt werden kann, wodurch zwar die Leitfähigkeit der a-C:H- Schicht zunimmt, aber ihre hervorragenden Eigenschaften bezüglich der Zuverlässigkeit unter Gleichspannungsbelastung erhalten bleiben.

Ein Verfahren mit einem Prozeß zur Strukturierung der a-C:H- Schicht konnte entwickelt werden und wird vorgestellt. Weiterhin konnte auf die gewonnenen Erkenntnisse aufbauend ein Verfahren zur zuverlässigen Passivierung von Halbleiterbauelementen mit einer Sperrspannung von größer als 3.000 Volt mit einer undotierten a-C:H- Schicht erarbeitet werden.

Die erfinderische Idee wird nachfolgend auf der Grundlage der Figuren 1 bis 4 beschrieben.

**Fig. 1** skizziert die Randstrukltur eines Chips nach dem Stand der Technik.

**Fig. 2** stellt in Diagrammform den Feldverlauf in dem Bereich des Feldringe dar.

**Fig. 3** gibt eine Übersicht über das erfinderische Verfahren an.

**Fig. 4** zeigt einen Teilausschnitt der erzeugten Randstruktur.

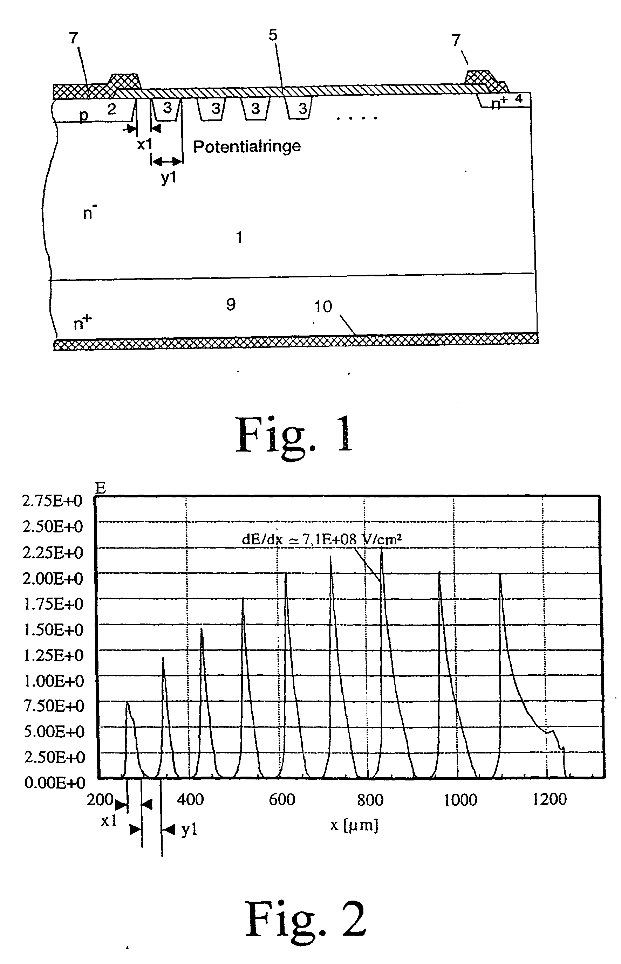

**Fig. 1** skizziert die Randstruktur eines Chips nach dem Stand der Technik. Es ist die Planarstruktur mit den Feldringen in nicht maßstabsgerechter Darstellung eines Ausschnittes des Chipquerschnittes, wie sie dem Stand der Technik entspricht, gezeichnet. Dargestellt ist der n-dotierte Halbleiterkörper (1) mit der durch Diffusion erzeugten p- Zone (2), der Anode. Die Feldringe (3) sind teilweise angedeutet.

Die Dotierung der Feldringe (3) besitzt an der Oberfläche, am Übergang zu der Passivierungsschicht (5), eine Konzentration von 10¹⁸ Atome pro cm⁻³. Durch diese im Vergleich mit Mesa- Strukturen (geschliffene Randstrukturen analog DE 40 13 435) hohe Dotierung ist die Bildung von Inversionsschichten in der p- Zone unkritisch. Es ist keine Dotierung der a-C:H-Schicht erforderlich.

Die Abstände (xᵢ) der Feldringe (3) untereinander sind ungleich, wie das in DE 196 06 983 A1 beschrieben wurde. Die Breite (yᵢ) der Feldringe (3) kann gleich gestaltet werden. Die Passivierungsschicht (5) besitzt nach deren Strukturierung eine flächige Ausdehnung über den gesamten Bereich der Feldringe (3), sie endet einerseits am Chiprand oberhalb eines eindiffundierten Kanalstoppers (4) und andererseits oberhalb der p- Zone (2). Die bondfähige Vorderseitenmetallisierung (7) dehnt sich von der Anode (2) noch bis über die Passivierungsschicht (5) aus. Zum Potentialausgleich ist der Kanalstopper (4) in gleicher Weise zusammen mit der bondfähigen Metallisierung (7) der Anode kontaktiert.

Die Kathodenseite der Diode ist mit einer zusätzlich zur Grunddotierung (1) durch Diffusion eingebrachten n⁺- Schicht (9) versehen. Die Metallisierung (10) auf der Rückseite ist lötfähig und in üblicher Technologie aus mehreren Schichten zusammengesetzt.

**Fig. 2** stellt in Diagrammform den Feldverlauf (E) in dem Bereich des Feldringe in Abhängigkeit von der Randlage (x) dar. Das elektrische Feld wird nur dort aufgenommen, wo die niedrig dotierte Zone (1) bis zur Chipoberfläche der Diode reicht, das ist unter den Abständen xᵢ der Fall.

In den Gebieten der Feldringe (3) kann das elektrische Feld nur wenig eindringen, wodurch unter dem Bereich yᵢ die Feldstärke sehr klein ist. Durch die hohen Feldstärken in den Bereichen xᵢ und den sehr geringen in den Bereichen yᵢ mit sehr abrupten Übergängen ergeben sich große Feldgradienten dE/dx, wie das aus dem Diagramm der Fig. 2 zu ersehen ist. Den Feldgradienten entspricht die Flankensteilheit der in Fig. 2 dargestellten Feldspitzen zwischen den Potentialringen.

Die Analyse der Randstruktur zeigt Feldgradienten dE/dx von mindestens 7,1E8V/cm². Damit wird der Bereich der in DE 40 13 435 A1 angegebenen Bedingung verlassen. Bei den dort verwendeten geschliffenen Randstrukturen liegt dE/dx bei kleineren Werten.

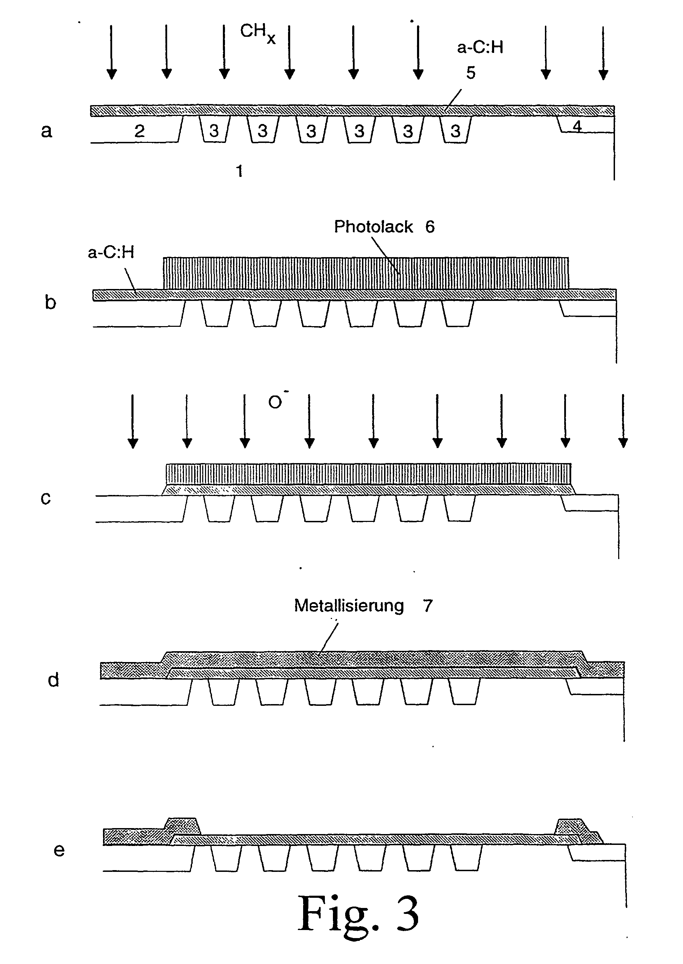

**Fig. 3** gibt eine Übersicht über das erfinderische Verfahren an. Die Kettung der technologischen Verfahrensschritte wird in den Stufen a bis e dargestellt. Es ist ein Querschnitt des Randbereiches eines Halbleiterbauelementes skizziert. Zunächst werden im Rahmen der Basistechnologie im Halbleiterwafer (1) die aktive Strukturen, die Anodenzone (2) und die Potentialringe (3), erzeugt.

Ebenfalls kann der in vielen planaren Prozessen übliche Kanalstopper (4) ausgebildet sein. Die Anordnung der Potentialringe (3) und ihre Erzeugung sind bekannter Stand der Technik. Vor Abscheiden der a-C:H- Schicht werden alle im Prozeß entstehenden planaren Oxydschichten chemisch entfernt und unmittelbar vor dem Abscheiden wird ein eventuell vorhandenes Restoxyd beseitigt.

Auf die so vorbehandelte Oberfläche der Planarstruktur wird in einem Plasma- Reaktor eine undotierte a-C:H- Schicht (5) mit einer Dicke zwischen 0,12µm und 0,24µm ganzflächig abgeschieden (Fig. 3a). Als Trägergas kann Methan (CH₄) oder Ethen (C₂H₄) verwendet werden. Es ist vorteilhaft, diesen Prozeß bei einer Self- Bias- Spannung zwischen 700V und 1.000V durchzuführen. Die Temperatur des Wafers sollte auf 140°C gehalten werden, maximal sind in jedem Falle 180°C zu unterschreiten.

In einem nächsten Prozeßschritt (Fig. 3b) wird auf diese a-C:H- Schicht eine Fotolackschicht (6) in einer Dicke zwischen 2µm und 8µm aufgebracht und fotolithografisch strukturiert.

In einem weiteren Prozeßschritt (Fig. 3c) wird die a-C:H- Schicht in einem Sauerstoff- Plasma geätzt. Dabei muß die Self- Bias- Spannung zwischen 120V und 500V betragen. Die Temperatur des Wafers darf 160°C nicht überschreiten. Bei diesem Schritt wird gleichzeitig die Fotolackschicht teilweise angeätzt. Deren Dicke ist so gewählt, daß noch nach Abschluß des Plasma- Ätzprozesses eine Restlackschicht vorhanden ist.

Nach Entfernen des restlichen Photolacks wird der Wafer gereinigt und nach einer weiteren chemischen Vorbehandlung in einer Lösung aus verdünnter wäßriger Flußsäure kann die ganzflächige Metallisierung (7) erfolgen (Fig. 3d). Für bondfähige Bauelemente bietet sich eine Metallisierung aus Aluminium an. Andere Metallisierungen nach dem Stand der Technik sind möglich. Die Dicke der Metallisierung sollte mindestens 4µm, höchstens jedoch 10µm betragen.

Die Strukturierung der Metallisierung (Fig. 3e) kann in einem Fotolithografie- mit einem anschließenden Ätzschritt erfolgen. Die a-C:H- Schicht erweist sich gegen wäßrige chemische Ätzmedien als sehr beständig. Die Kontaktierung der nicht dargestellten Kathodenseite des Wafers erfolgt ganzflächig nach dem Stand der Technik mittels einer lötfähigen Metallisierung.

Zur Erzielung zuverlässiger galvanischer Kontakte und ausreichender Haftung der Metallisierung auf Silizium, ist ein Temperprozeß der Metalle notwendig. Dieser Temperprozeß wird bei einer Temperatur zwischen 360°C und 440°C über 5 bis 10 Min. durchgeführt, vorzugsweise zwischen 390°C und 430°C. Er erfolgt in einer Atmosphäre aus Stickstoff und Wasserstoff (Formiergas).

Bei dem beschriebenen Temperprozeß erhöht sich der Sperrstrom des Halbleiterbauelementes merklich. War der Sperrstom einer 3.300 Volt- Struktur vor dem Tempern kleiner als 3µA bei 3.300V und 25°C, so werden nach dem Tempern typisch 30µA Sperrstrom gemessen. Dies ist ein Anzeichen für eine bereits eingesetzte Graphitisierung in der a-C:H- Schicht, wodurch die Leitfähigkeit erhöht wird. Der Sperrstrom ist stabil und liegt noch in einem Bereich, in dem er für die Verlustleistung bei vorgegebenen Einsatzgebieten akzeptabel ist.

Bei einem schnellen Halbleiterbauelement erfolgt nach Aufbringen der Kontaktierungen für die Vorder- und Rückseite die Implantation von Protonen oder He⁺⁺- Kernen und/oder die Elektronenbestrahlung. Da die strahlungsinduzierten Rekombinationszentren thermisch aktiviert werden können, ist für langzeitstabile lötfähige Bauelemente ein Ausheilschritt bei einer Temperatur größer der höchsten möglichen Löttemperatur und einer Zeit von mindestens 30 Min. erforderlich. Dieser Ausheilschritt wird bei Temperaturen zwischen 330°C und 360°C unter Formiergas durchgeführt. Die durch He⁺⁺- Bestrahlung erzeugten Zentren werden, wie das in DE 43 10 444 C2 beschrieben ist, in der p- Zone der dort beispielhaft gewählten Freilaufdiode angeordnet.

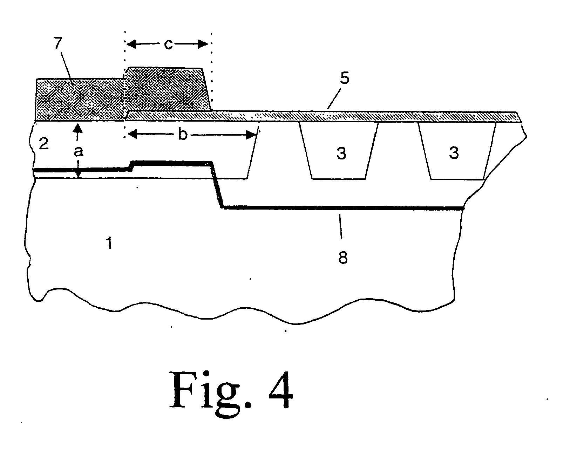

**Fig. 4** zeigt einen Teilausschnitt der mittels des erfindungsgemäßen Verfahrens erzeugten Randstruktur. Dargestellt ist die Oberflächenstruktur einer schnellen Leistungsdiode in dem Bereich des Überganges der Anoden-zone (2) zu den Potentialringen (3). Der Wafer-Grundkörper (1) und die Kontaktmetallisierung (7) sind skizziert. Die geometrische Lage der a-C:H- Schicht (5) über der Anodenzone ist dargestellt. Durch die Bestrahlung mit Protonen oder He⁺⁺- Ionen ist eine Zone hoher Dichte an Rekombinationszentren (8) hergestellt worden.

Gegenüber Halbleiterbauelementen mit einer passivierenden Planarschicht aus Siliziumdioxid ist die mittels des erfindungsgemäßen Verfahrens hergestellte a-C:H- Schicht mit 120nm bis 240nm relativ dünn. Bei Implantation von He⁺⁺- Ionen oder Protonen erfolgt das Abbremsen der Ionen aufgrund der vergleichbaren Atompackungsdichte von Silizium, Siliziumdioxid und Aluminium in vergleichbarer Weise, was somit zu analogen Eindringtiefen (8) der strahlungsinduzierten Zentren führt. Der Verlauf der Schicht (8) wird daher die Gesamtoberfläche widerspiegeln und es wird sich ein Bestrahlungsprofil im Bauelement ausbilden, wie es in Fig. 4 dargestellt ist.

Mittels des erfindungsgemäßen Verfahrens hergestellte Halbleiterbauelemente mit den dargestellten planaren Passivierungsschichten (auf der Anodenseite bei Dioden) besitzen auf der Kathodenseite zwangsläufig eine größere Fläche, da anodenseitig Platz für die Feldringstrukturen verbraucht wurde. Diese zur Erzielung der hohen Sperrspannung erforderlichen Randgebiete stehen für den Stromtransport in Durchlaßrichtung nicht mehr zur Verfügung. Die Stromdichte in den Anodenrandgebieten ist zu der der übrigen Anodengebiete vergleichsweise größer. Bei der Kommutierung wird dadurch bedingt in diesen Anodenrandbereichen eine höhere Stromdichte vorliegen, was die dynamische Robustheit negativ beeinträchtigt. Dabei wird unter dynamischer Robustheit die Fähigkeit verstanden, hohen Kommutierungssteilheiten (>2.000A/cm²µs) und hohen Zwischenkreisspannungen (>²/₃ der spezifizierten Sperrspannung) Stand halten zu können.

Bei der Dimensionierung eines solchen Halbleiterbauelementes ist daher zu beachten, daß der Randbereich, hier beispielhaft der Anodenbereich der Leistungsdiode, nicht höher als der restliche Teil belastet wird. Das wird durch einen nicht kontaktierten Bereich der Breite "b" in der Anodenzone erreicht. Dabei wird zugrunde gelegt, daß diese Breite "b" größer als die doppelte Eindringtiefe "a" der p- Zone oder aber zumindest größer als 50µm ist.

Die Überlappung der Metallisierung über der a-C:H- Schicht erfolgt über die Breite "c". Damit kann über dem Bereich "b" ein laterales Tiefenprofil der Rekombinationszentren eingestellt werden. Bei Leistungsdioden ist anzustreben, daß "c" größer als die Eindringtiefe "a" ist, die Metallisierung kann jedoch auch soweit über "b" hinausreichen, daß die Sperrfähigkeit der Potentialringstruktur nicht beeinträchtigt wird.

## Patentansprüche

1. Verfahren zur Passivierung einer schnellen Leistungsdiode in Planartechnologie mit den folgenden Merkmalen:
einem weichen Schaltverhalten mit einem Halbleiterkörper, der eine Folge schichtförmiger Zonen auweist, von welchen eine hochohmige, mittlere Zone (1) einen ersten Leitungstyp besitzt, der an einer Außenzone (2) vom zweiten Leitungstyp einen pn- Übergang einschließt, und über eine Potentalringstruktur (3) mit einer entsprechend der Sperrspannung notwendigen Anzahl von Potentialringen verfügt,wobei
a) auf der oxidfreien Halbleiteroberfläche eine a-C:H- Schicht (5) mittels Plasma- Abscheidung erzeugt wird, wobei die Self- Bias- Spannung zwischen 700V und 1.000V eingestellt wird, wobei die Temperatur des Wafers zwischen 140°C und 180°C beträgt,
b) auf die a-C:H- Schicht eine Fotolackschicht (6) der Dicke zwischen 2µm und 8µm aufgebracht und strukturiert wird,
c) die a-C:H- Schicht in einem sauerstoffhaltigen Plasma bei einer Self Bias- Spannung zwischen 120V und 500V geätzt wird wobei die Temperatur des Wafers 160°C nicht überschreitet und wobei die Fotolackschicht in abgedünnter Form erhalten bleibt,
d) eine Metallisierung (7) der Dicke zwischen 4µm und 8µm aufgebracht und strukturiert wird und
e) der Wafer bei einer Temperatur zwischen 360°C und 440°C zur Erreichung einer guten Haftung der Metallisierung getempert wird,
wobei die Schrittreihenfolge a), b), c), d), e) ist.

2. Verfahren nach Anspruch 1, **dadurch gekennzeichnet, daß**
die a-C:H- Schicht die Anode (2) von der Seite der Ringstruktur (3) aus um eine Länge "b" abgedeckt wird, wobei die Länge "b" mindestens der doppelten Eindringtiefe "a" der Anode (2) in die Grunddotierung (1) des Wafers entspricht.

3. Verfahren nach Anspruch 2, **dadurch gekennzeichnet, daß**
die a-C:H- Schicht die Anode (2) von der Seite der Ringstruktur aus um eine Länge "b" abdeekt die mindestens 50µm beträgt.

4. Verfahren nach Anspruch 1, **dadurch gekennzeichnet, daß**
die Kontaktmetallisierung (7) die a-C:H- Schicht um die Breite "c" überlappend angeordnet wird, wobei die Überlappung "c" größer der Länge der Abdeckung "b" ist.

5. Verfahren nach Anspruch 1, **dadurch gekennzeichnet, daß**
die Kontaktmetallisierung (7) die a-C:H- Schicht um die Breite "c" überlappend angeorndet wird, wobei die Überlappung "c" kleiner der Länge der Abdeckung "b", jedoch größer der Eindringtiefe "a" ist und mindestens 25µm beträgt.

## Claims

1. A method of passivating a high-speed power diode in planar technology with the following features:
smooth switching behaviour with a semiconductor body displaying a series of layered zones, of which a high-impedance, central zone (1) has a first circuit type, which includes a pn-junction on an outer zone (2) of the second conductor type, and having a potential ring structure (3) with a necessary number of potential rings depending on the blocking voltage, wherein
a) an a-C:H layer (5) is produced on the oxide-free semiconductor surface by means of plasma deposition, wherein the self-bias-voltage is set at between 700 V and 1000 V, wherein the temperature of the wafer is between 140°C and 180 °C,
b) a photoresist layer (6) between 2 µm and 8 µm thick is applied to the a-C:H layer and structured,
c) the a-C:H layer is etched in an oxygen plasma at a self-bias voltage of between 120 and 500 V, wherein the wafer temperature does not exceed 160 °C and the photoresist layer is retained in diluted form,
d) metallisation (7)with a thickness of between 4 µm and 8 µm is applied and structured and
e) the wafer is tempered at a temperature of between 360 °C and 440 °C, in order to achieve good adhesion of the metallisation,
wherein the sequence of stages is a), b), c), d) and e).

2. The method according to claim 1, **characterised in that**
the a-C:H layer covers the anode (2) from the side of the ring structure (3) by a length "b", wherein the length "b" corresponds to at least twice the penetration depth "a" of the anode (2) in the basic doping (1) of the wafer.

3. The method according to claim 2, **characterised in that** the a-C:H layer covers the anode (2) from the side of the ring structure by a length "b" of at least 50 µm.

4. The method according to claim 1, **characterised in that**
the contact metallisation (7) is disposed such that it overlaps the a-C:H layer by width "c", wherein the overlap "c" is greater than the cover length "b".

5. The method according to claim 1, **characterised in that**
the contact metallisation (7) is disposed such that it overlaps the a-C:H layer by width "c", wherein the overlap "c" is smaller than the length of the cover "b", but larger than the penetration depth "a" and is at least 25 µm.

## Revendications

1. Procédé de passivation en technologie planaire d'une diode de puissance rapide, présentant les particularités suivantes :
un comportement doux à la commutation, un corps semi-conducteur comportant une succession de zones en forme de couches, dont une zone centrale (1) de valeur ohmique élevée possède un premier type de puissance, qui inclut une jonction pn au niveau d'une zone extérieure (2) d'un deuxième type de puissance, et dispose d'une structure à anneaux de potentiel (3) avec un nombre d'anneaux de potentiel nécessaire en fonction de la tension de blocage, dans lequel
a) une couche en a-C:H (5) est engendrée sur la surface exempte d'oxyde du semi-conducteur au moyen d'un dépôt par plasma, la tension d'autopolarisation étant réglée entre 700 V et 1000 V, et la température de la tranche étant comprise entre 140 °C et 180 °C,
b) une couche de laque photosensible (6) d'une épaisseur comprise entre 2 µm et 8 µm est appliquée et structurée sur la couche en a-C:H,
c) la couche en a-C:H est décapée dans un plasma contenant de l'oxygène à une tension d'autopolarisation comprise entre 120 V et 500 V, la .température de la tranche ne dépassant en l'occurrence pas 160 °C, et la couche de laque photosensible restant conservée à 1'état aminci,
d) une métallisation (7) de l'épaisseur comprise entre 4 µm et 8 µm est appliquée et structurée, et
e) la tranche est mise en équilibre à une température comprise entre 360 °C et 440 °C pour l'obtention d'une bonne adhérence de la métallisation,
l'ordre de succession des phases étant a), b), c), d), e).

2. Procédé selon la revendication 1, **caractérisé en ce que**
la couche en a-C:H recouvre l'anode (2) à partir du côté de la structure annulaire (3) d'une longueur "b", la longueur "b" correspondant au moins au double de la profondeur de pénétration "a" de l'anode (2) dans le dopage de base (1) de la tranche.

3. Procédé selon la revendication 2, **caractérisé en ce que**
la couche en a-C:H recouvre l'anode (2) à partir du côté de la structure annulaire d'une longueur "b", qui est au moins de 50 µm.

4. Procédé selon la revendication 1, **caractérisé en ce que**
la métallisation de contact (7) est disposée en chevauchant la couche en a-C:H de la largeur "c", le chevauchement "c" étant plus important que la longueur du recouvrement "b".

5. Procédé selon la revendication 1, **caractérisé en ce que**
la métallisation de contact (7) est disposée en chevauchant la couche en a-C:H de la largeur "c", le chevauchement "c" étant moins important que la longueur du recouvrement "b", mais plus important que la profondeur de pénétration "a", et étant au moins de 25 µm.
